# EUROPÄISCHE PATENTANMELDUNG

(11) **EP 1 091 491 A1**
(43) Veröffentlichungstag der Anmeldung: **11.04.2001**
(21) Anmeldenummer: 00119901.7
(22) Anmeldetag: 13.09.2000
(51) Int. Cl.: H03K 19/00, H03K 3/3565

(54) **Inputbuffer einer integrierten Halbleiterschaltung**

(30) Priorität: 15.09.1999 DE 19944248
(71) Anmelder: Infineon Technologies AG, 81669 München (DE)
(72) Erfinder: Feurle, Robert, 85579 Neubiberg (DE)
(74) Vertreter: Fischer, Volker, Dipl.-Ing.

(57) **Zusammenfassung**

Eine integrierte Halbleiterschaltung mit einer ersten Betriebsart und einer zweiten Betriebsart weist mehrere Inputbuffer (IB1; IBn) auf, wobei wenigstens eines der Inputbuffer (IB1) zur Steuerung der Umschaltung zwischen den Betriebsarten dient. Das Inputbuffer (IB1) zur Steuerung der Umschaltung zwischen den Betriebsarten weist eine Treiberschaltung (10) mit einer Inverterschaltung (11) mit geringen statischen Verlustströmen auf, die in der ersten und zweiten Betriebsart bestimmungsgemäß betreibbar ist. Die übrigen Inputbuffer (IB2; IBn) weisen jeweils eine Differenzverstärkerschaltung (DA) auf, die in der zweiten Betriebsart abgeschaltet ist. Durch die auch bei niedrigen Versorgungsspannungen zuverlässig schaltende Inverterschaltung wird eine reduzierte Mindeststromaufnahme der Halbleiterschaltung erreicht.

## Beschreibung

Die vorliegende Erfindung betrifft Inputbuffer einer integrierten Halbleiterschaltung mit unterschiedlichen Betriebsarten.

Integrierte Schaltungen weisen Eingangspuffer auf, allgemein auch als Inputbuffer bezeichnet, zur Verbindung der integrierten Schaltung beispielsweise mit externen Eingangssignalen. Häufig verwendete Treiberschaltungen für Inputbuffer sind beispielsweise CMOS-Inverterschaltungen bekannter Art, die sich vor allem durch hohe Schaltgeschwindigkeiten und geringe statische Verlustströme auszeichnen.

Insbesondere bei integrierten Schaltungen mit vergleichsweise niedriger Versorgungsspannung sind einfache CMOS-Inverterschaltungen nicht mehr zufriedenstellend in ihrer bestimmungsgemäßen Funktion betreibbar. Durch teilweise niedrigere Schaltschwellen der Inverterschaltung besteht zum Teil die Gefahr, daß die Schaltpegel der Eingangssignale fehlerhaft detektiert werden. Die Folge davon können fehlerhafte Schaltvorgänge sein. Diese können außerdem zunehmend verursacht werden durch eingelagerte Störsignale, da die Störempfindlichkeit einer Inverterschaltung mit einer niedrigeren Versorgungsspannung durch niedrigere Schaltpegel zunimmt.

Zur Vermeidung der oben genannten Nachteile weisen Treiberschaltungen von Inputbuffern beispielsweise Differenzverstärker auf, bei welchen an einen Eingang das Eingangssignal und an den anderen Eingang ein veränderbares Referenzpotential zur Steuerung der Schaltschwelle angelegt ist. Durch eine Differenzverstärkerschaltung fließt im allgemeinen jedoch ein statischer Strom, der beispielsweise bei Verwendung mehrerer Inputbuffer mit Differenzverstärkern zu einer erheblichen Mindeststromaufnahme der integrierten Schaltung führen kann.

Um in einem Stromsparbetrieb im Vergleich zu einem Normalbetrieb der integrierten Schaltung eine geringere Stromaufnahme zu erzielen, werden Differenzverstärker von Imputbuffern, die im Stromsparbetrieb nicht benötigt werden, zumeist abgeschaltet. Die Inputbuffer bzw. Differenzverstärker, deren Eingangssignale zur Steuerung der Umschaltung zwischen den Betriebsarten der Halbleiterschaltung dienen, verbleiben entweder im aktiven Zustand, um eine schnelle Umschaltung zu gewährleisten, oder sie werden ebenfalls abgeschaltet. Dies führt zu einer relativ langen Aktivierungszeit des betreffenden Inputbuffers.

Die Aufgabe der vorliegenden Erfindung ist es, eine Halbleiterschaltung mit Inputbuffern anzugeben, die in einer von mehreren Betriebsarten der Halbleiterschaltung einen insgesamt möglichst geringen Stromverbrauch der Inputbuffer aufweist bei einem vergleichsweise geringen Flächenbedarf.

Die Aufgabe wird gelöst durch eine integrierte Halbleiterschaltung nach den Merkmalen des Patentanspruchs 1. Vorteilhafte Aus- und Weiterbildungen sind Gegenstand abhängiger Ansprüche.

Die integrierte Halbleiterschaltung enthält mehrere Inputbuffer, die jeweils einen Anschluß für ein Eingangssignal aufweisen. Zur Steuerung der Umschaltung zwischen einer ersten Betriebsart und einer zweiten Betriebsart der Halbleiterschaltung dient wenigstens eines der Inputbuffer, die eine Treiberschaltung mit einer Inverterschaltung aufweist, die in der ersten und zweiten Betriebsart bestimmungsgemäß betreibbar ist. Die übrigen Inputbuffer weisen jeweils eine Differenzverstärkerschaltung auf, die in der zweiten Betriebsart abgeschaltet ist. Bei der ersten Betriebsart handelt es sich beispielsweise um einen Normalbetrieb der Halbleiterschaltung, bei der zweiten Betriebsart um einen stromsparenden Betrieb der Halbleiterschaltung, der im Vergleich zum Normalbetrieb eine geringere Mindeststromaufnahme aufweist.

Da für die Steuerung der Umschaltung zwischen den Betriebsarten eine Treiberschaltung mit einer Inverterschaltung verwendet wird, wird im Vergleich zur Verwendung einer Differenzverstärkerschaltung eine geringere statische Mindeststromaufnahme erreicht. Die Inverterschaltung ist dabei so ausgelegt, daß sie auch bei Anwendungen mit vergleichsweise niedriger Versorgungsspannung im Vergleich zu einer Differenzverstärkerschaltung ein ähnlich gutes und zuverlässiges Schaltverhalten aufweist. Die Inverterschaltung des Inputbuffers ist somit in der ersten und zweiten Betriebsart bestimmungsgemäß betreibbar. Die für die zweite Betriebsart nicht benötigten Inputbuffer bzw. deren Differenzverstärker sind zur Reduzierung der statischen Mindeststromaufnahme in der zweiten Betriebsart abgeschaltet.

Die erfindungsgemäße Halbleiterschaltung zeichnet sich außerdem durch einen vergleichsweise geringen Platzbedarf aus, da die Inverterschaltung in beiden Betriebsarten bestimmungsgemäß betreibbar ist und somit keine zusätzliche Schaltung etwa zu einer Differenzverstärkerschaltung notwendig ist. Die erfindungsgemäße Halbleiterschaltung ist deshalb vorteilhaft vor allem bei Schaltungen einsetzbar, die für einen Betrieb in mobilen Anwendungen vorgesehen sind, wie beispielsweise Mobiltelefonen oder Laptops.

In einer erfindungsgemäßen Ausführungsform weist die Inverterschaltung Schalttransistoren und einen Hysterese-Transistor auf, dessen Steueranschluß am Ausgang der Treiberschaltung angeschlossen ist und dessen gesteuerte Strecke parallel zu der gesteuerten Strecke eines der Schalttransistoren geschaltet ist. Durch das Vorsehen des Hysterese-Transistors wird die Schaltschwelle der Inverterschaltung insbesondere bei einem bisher kritischen Low-High-Übergang des Eingangssignals hin zu höheren Schaltschwellen verschoben.

In einer vorteilhaften Weiterbildung weist die Treiberschaltung des Inputbuffers zur Steuerung der Umschaltung zwischen den Betriebsarten eine weitere Inverterschaltung auf, die der oben genannten Inverterschaltung nachgeschaltet ist. Durch die Anordnung der weiteren Inverterschaltung vor dem Steueranschluß des Hysterese-Transistors wird neben einer vollständigen Sperrung des Hysterese-Transistors auch eine größere Flankensteilheit des Ansteuersignals für den Steuereingang des Hysterese-Transistors erreicht, so daß dieser sehr kurze Schaltzeiten aufweist.

In einer weiteren Ausgestaltung der erfindungsgemäßen Inverterschaltung weist diese wenigstens zwei Schalttransistoren unterschiedlichen Leitungstyps auf, die je nach Leitungstyp unterschiedlich dimensioniert sind. Beispielsweise werden bei Verwendung einer CMOS-Inverterstufe die P-Kanal-Transistoren hinsichtlich ihrer Stromergiebigkeit stärker dimensioniert als die N-Kanal-Transistoren. Auf diese Art wird die bei geringeren Versorgungsspannungen reduzierte Leitfähigkeit der P-Kanal-Transistoren zumindest teilweise ausgeglichen. In diesem Zusammenhang ist es ebenso möglich, alternativ oder zusätzlich zu der unterschiedlichen Dimensionierung der Schalttransistoren eine größere Anzahl von P-Kanal-Transistoten parallel zu schalten, um auf diese Art die Stromergiebigkeit der P-Kanal-Transistoren zu erhöhen.

Die Erfindung wird im folgenden anhand der in der Zeichnung dargestellten Figuren näher erläutert. Es zeigen:
- Figur 1: eine schematische Darstellung einer integrierten Halbleiterschaltung mit Inputbuffern,
- Figur 2: eine Treiberschaltung eines Inputbuffers mit einem Differenzverstärker,
- Figur 3: eine Treiberschaltung eines Inputbuffers mit einer Inverterschaltung.

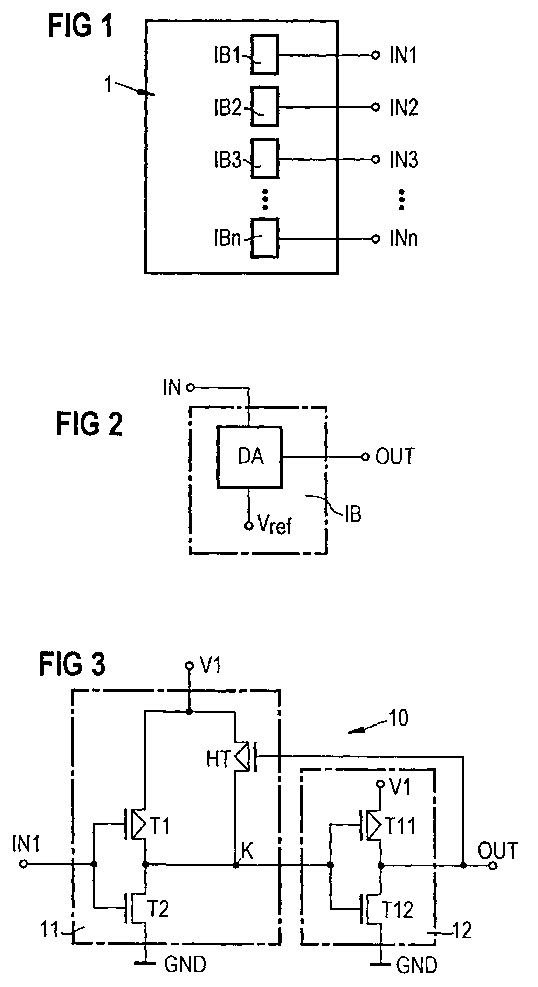

In Figur 1 ist eine schematische Darstellung einer integrierten Halbleiterschaltung 1 mit Inputbuffern IB1 bis IBn gezeigt. Die Inputbuffer IB1 bis IBn weisen jeweils Anschlüsse für Eingangssignale IN1 bis INn auf. Die Halbleiterschaltung 1 weist eine erste Betriebsart und eine zweite Betriebsart auf, die beispielsweise für einen Normalbetrieb bzw. einen stromsparenden Betrieb (Power-down) der Halbleiterschaltung vorgesehen ist. Zur Steuerung der Unschaltung zwischen den Betriebsarten ist hier beispielsweise das Inputbuffer IB1 vorgesehen. Durch dessen Eingangssignal IN1 wird gesteuert, ob sich die integrierte Halbleiterschaltung 1 in der ersten Betriebsart oder in der zweiten Betriebsart befindet. Insbesondere bei integrierten Halbleiterspeichern, wie z. B. synchronen DRAM, werden hierzu auch zwei Eingangssignale verwendet. Bei einem entsprechenden Aktivierungssignal wird bei einem nächsten aktiven Taktsignal der Halbleiterspeicher aus dem Power-down-Betriebsmodus in den Normalbetrieb geschaltet. Ziel dabei ist, möglichst unverzüglich nach der Schaltflanke des aktiven Taktsignals den Halbleiterspeicher wieder vollständig in Betrieb zu nehmen.

Die in Figur 1 dargestellten übrigen Inputbuffer IB2 bis IBn weisen Differenzverstärkerschaltungen auf. Eine Treiberschaltung eines der Inputbuffer IB2 bis IBn mit einem Differenzverstärker ist in Figur 2 dargestellt. Die Eingangssignale des Differenzverstärkers DA sind die Signale IN und das Referenzpotential V_{ref} zur Einstellung der Schaltschwelle des Differenzverstärkers DA. Das Ausgangssignal des Inputbuffers IB ist das Signal OUT. Um die statische Mindeststromaufnahme der Inputbuffer möglichst gering zu halten, sind die für einen Betrieb in der zweiten Betriebsart nicht benötigten Inputbuffer IB2 bis Ibn abgeschaltet.

Figur 3 zeigt eine Ausführungsform einer Treiberschaltung des Inputbuffers IB1 zur Steuerung der Umschaltung zwischen den Betriebsarten. Die Treiberschaltung 10 weist eine Inverterschaltung 11 auf mit den Schalttransistoren T1 und T2, deren Steueranschlüsse an das Eingangssignal IN1 angeschlossen sind. Die Transistoren T1 und T2 sind mit ihren gesteuerten Strecken in Reihe geschaltet, wobei der Transistor T1 vom P-Kanal-Typ an einer positiven Versorgungsspannung V1 und Transistor T2 vom N-Kanal-Typ an einem Bezugspotential GND anliegt. Der Inverterschaltung 11 nachgeschaltet ist eine Inverterschaltung 12 mit ihren Schalttransistoren T11 und T12, die analog der Inverterschaltung 11 verschaltet sind. Die Inverterschaltung 11 weist ferner einen Hysterese-Transistor HT auf, dessen Steueranschluß am Ausgang der Treiberschaltung 10 mit dem Ausgangssignal OUT angeschlossen ist, und dessen gesteuerte Strecke parallel zu der gesteuerten Strecke des Transistors T1 geschaltet ist.

Ist der Hysterese-Transistor HT im leitenden Zustand (Signal IN1 im Low-Zustand, d. h. auf Bezugspotential GND), so wird beim nächsten Übergang des Signals IN1 in den High-Zustand (Versorgungspotential V1) die Schaltschwelle der Inverterschaltung 11 hin zu höheren Potentialwerten verschoben. Dies führt dazu, daß beispielsweise bei vergleichsweise niedrigen Versorgungsspannungen relativ hohe Störspannungen, die jedoch noch unterhalb der erhöhten Schaltschwelle liegen, nicht zu fehlerhaften Schaltvorgängen der Treiberschaltung 10 führen. Ein High-Low-Übergang wird von einer vergleichsweise niedrigen Versorgungsspannung im allgemeinen nicht beeinflußt.

Dieser Effekt kann unterstützt werden durch eine asymetrische Dimensionierung der Schalttransistoren T1 und T2. Der P-Kanal-Transistor T1 wird hinsichtlich seiner Stromergiebigkeit stärker dimensioniert als der N-Kanal-Transistor T2. Ebenso ist es möglich, mehrere dem Transistor T1 parallel geschaltete P-Kanal-Transistoren vorzusehen, die insgesamt die Leitfähigkeit erhöhen.

Durch die weitere Inverterschaltung 12, an deren Ausgang der Steueranschluß des Hysterese-Transitors HT angeschlossen ist, werden dessen Schaltflanken beschleunigt. Am Knoten K genügt bereits ein Potentialwert in Höhe der Schwellspannung der Inverterschaltung 12, um den Hysterese-Transistor HT vollständig leitend bzw. sperrend zu schalten. Dies kann dazu beitragen, die Schaltgeschwindigkeit der Treiberschaltung 10 insgesamt zu erhöhen.

## Patentansprüche

1. Integrierte Halbleiterschaltung
- mit einer ersten Betriebsart und einer zweiten Betriebsart der Halbleiterschaltung (1),
- mit mehreren Inputbuffern (IB1; IBn), die jeweils einen Anschluß für ein Eingangssignal (IN1; INn) aufweisen,
- mit wenigstens einem der Inputbuffer (IB1) zur Steuerung der Umschaltung zwischen den Betriebsarten durch dessen Eingangssignal (IN1),
- bei dem das Inputbuffer (IB1) zur Steuerung der Umschaltung zwischen den Betriebsarten eine Treiberschaltung (10) mit einer Inverterschaltung (11) aufweist, die in der ersten und zweiten Betriebsart bestimmungsgemäß betreibbar ist,
- bei dem die übrigen Inputbuffer (IB2; IBn) jeweils eine Differenzverstärkerschaltung (DA) aufweisen, die in der zweiten Betriebsart abgeschaltet ist.

2. Integrierte Halbleiterschaltung nach Anspruch 1,
**dadurch gekennzeichnet**, daß
die erste Betriebsart für einen Normalbetrieb und die zweite Betriebsart für einen stromsparenden Betrieb der Halbleiterschaltung (1) vorgesehen ist.

3. Integrierte Halbleiterschaltung nach einem der vorhergehenden Ansprüche,
**dadurch gekennzeichnet**, daß
die Inverterschaltung (11) Schalttransistoren (T1, T2) und einen Hysterese-Transistor (HT) aufweist, dessen Steueranschluß am Ausgang (OUT) der Treiberschaltung (10) angeschlossen ist und dessen gesteuerte Strecke parallel zu der gesteuerten Strecke eines der Schalttransistoren (T1) geschaltet ist.

4. Integrierte Halbleiterschaltung nach Anspruch 3,
**dadurch gekennzeichnet**, daß
die Inverterschaltung (11) eine erste Inverterschaltung der Treiberschaltung (10) ist und die Treiberschaltung (10) eine weitere Inverterschaltung (12) aufweist, die der ersten Inverterschaltung (11) nachgeschaltet ist.

5. Integrierte Halbleiterschaltung nach einem der vorhergehenden Ansprüche,
**dadurch gekennzeichnet**, daß
die Inverterschaltung (11) wenigstens zwei Schalttransistoren (T1, T2) unterschiedlichen Leitungstyps aufweist, die je nach Leitungstyp unterschiedlich dimensioniert sind.
